# FASCICULE DE BREVET EUROPEEN

(11) **EP 2 649 566 B1**
(45) Date de publication et mention de la délivrance du brevet: **14.09.2016**
(21) Numéro de dépôt: 11794474.4
(22) Date de dépôt: 07.12.2011
(51) Int. Cl.: G06K 19/077

(54) **CARTE ÉLECTRONIQUE AYANT UN CONNECTEUR EXTERNE**
ELEKTRONISCHE KARTE MIT EINEN EXTERNEN ANSCHLUSS
ELECTRONIC CARD HAVING AN EXTERNAL CONNECTOR

(30) Priorité: 07.12.2010 EP 10194068
(43) Date de publication de la demande: 16.10.2013
(73) Titulaire: Nagravision S.A., 1033 Cheseaux-sur-Lausanne (CH)
(72) Inventeur: DROZ, François, CH-2035 Corcelles (CH)
(74) Mandataire: Surmely, Gérard
(86) Numéro de dépôt international: PCT/EP2011/072138
(87) Numéro de publication internationale: WO 2012/076627

(56) Documents cités:
- EP-A1- 2 001 077
- EP-A2- 0 818 752
- WO-A1-03/017196
- WO-A2-97/34247
- DE-A1- 19 732 645
- GB-A- 2 371 264
- US-A1- 2007 139 977

## Description

### Domaine de l'invention

La présente invention concerne le domaine des cartes électroniques, notamment du type bancaire, comprenant une unité électronique et/ou une antenne incorporée(s) dans le corps de cette carte et un connecteur externe agencé dans une cavité de ce corps de carte et présentant une pluralité de plages de contact agencées sur une face externe d'un support isolant formant ce connecteur. Cette pluralité de plages de contact sont reliées à une pluralité de plages de contact internes correspondantes qui sont reliées à ladite unité électronique et/ou ladite antenne et qui apparaissent dans la cavité ou qui sont électriquement reliées à une pluralité de plages de contact intermédiaires apparaissant dans cette cavité.

### Arrière-plan technologique

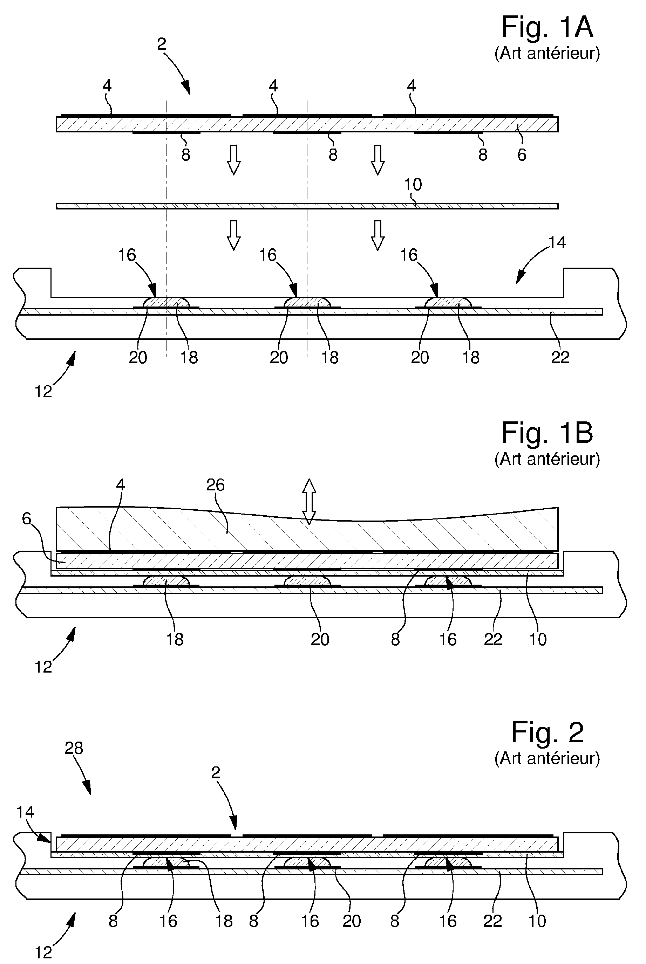

Aux figures 1A et 1B est représenté schématiquement un procédé industriel classique de fabrication de cartes électroniques du type mentionné ci-dessus. On fabrique premièrement un connecteur 2 et un corps de carte 12 présentant une cavité 14 destinée à recevoir le connecteur 2. Ce connecteur comprend des plages de contact externes 4 agencées sur une face externe du support 6 et des plages de contact internes 8 agencées sur la face interne de ce support. Les plages externes 4 sont reliées électriquement aux plages internes 8 par des moyens connus de l'homme du métier. Le corps de carte 12 comprend une pluralité de plages de contact 16 destinées à être connectées aux plages 8. Ces plages 16 apparaissent à une surface horizontale (parallèle au plan général de la carte) de la cavité 14. Chaque plage de contact 16 est formée d'une brasure 18, notamment de l'étain, déposée sur une plage interne 20 du corps de carte 12. Les plages 20 sont agencées à la surface d'un support 22 associé à une unité électronique et/ou une antenne incorporée dans le corps de carte 12 et reliée électriquement à ces plages 20 via un circuit électrique.

Un film de colle conductrice 10 et le connecteur 2 sont apportés dans la cavité 14 du corps de carte 12, le film de colle 10 étant agencé entre le fond de la cavité 14 et le connecteur 2. A l'aide d'une presse chauffante 26, le connecteur est fixé au corps de carte 12. A la figure 2 est représentée partiellement une carte 28 obtenue par le procédé de l'art antérieur décrit ici. Selon ce procédé classique, la colle conductrice 10 forme une couche entre les plages de contact internes 8 et les plages de contact 16 situées au niveau de la surface horizontale définissant le fond de la cavité 14.

Divers tests effectués sur les cartes du type de celui de la figure 2 et l'analyse des cartes défectueuses retournées par divers utilisateurs montrent que les connections électriques entre le connecteur externe 2 et les plages de contact 16 apparentes dans la cavité 14 ne sont pas fiables. Les cartes électroniques, notamment les cartes bancaires, doivent pouvoir subir diverses contraintes mécaniques étant donné que les utilisateurs les portent généralement soit dans leur portemonnaie, soit dans un porte-carte flexible. Les flexions ou les torsions subies par les cartes 28 avec des paires de plages de contact collées l'une à l'autre peuvent engendrer un décollement local au niveau de ces plages de contact ou même des interstices qui rompent alors la connexion électrique. Ainsi, de telles cartes électroniques ont un problème de longévité.

Il est connu du document DE 197 32 645 une carte électronique dans laquelle est incorporée une antenne. Cette carte comprend un évidement, dans lequel apparaissent à une surface horizontale deux première plages de contact respectivement reliés électriquement aux deux extrémités de l'antenne, et un module électronique introduit dans l'évidement, ce module ayant deux secondes plages de contact reliées électriquement aux deux premières plages. Chaque première plage est définie par la surface supérieure d'une bosse métallique tronquée. Pour établir la connexion électrique entre les premières et secondes plages, il est prévu de déposer sur les premières ou secondes plages soit une colle conductrice, soit une brasure permettant d'effectuer une soudure entre ces plages. La deuxième alternative permet d'obtenir des connexions plus robustes et électriquement meilleures. Cependant, la réalisation d'une soudure nécessite un apport de chaleur relativement important pour atteindre la température de soudage. Ce document propose d'apporter la chaleur au travers du support du module électronique, lequel est généralement constitué par un matériau isolant qui est un mauvais conducteur thermique, par exemple une résine renforcée ou du plastique. Un apport de chaleur important sur ce support risque de le déformer et même d'endommager le module électronique.

Il est connu du document WO 97/34247 une carte électronique du type décrit ci-avant où la brasure prévue entre les plages de contact est incorporée dans un film de colle. La brasure est incorporée notamment dans des ouvertures effectuées dans ce film de colle, lequel est ensuite apporté contre le substrat du module électronique de manière que la brasure soit superposée aux plages de contact internes de ce module. Finalement la colle est activée et la brasure est fondue par un apport de chaleur au travers du support isolant du module électronique. On a donc le même problème que dans le document précédent. De plus, l'apport de brasure dans des ouvertures d'un film de colle avant que celui-ci soit assemblé au module électronique pose des problèmes de fabrication, car il n'est pas évident d'assurer le maintien de la brasure dans les ouvertures du film de colle jusqu'à son assemblage au module électronique. Ainsi, dans une variante, il est prévu d'introduire des particules conductrices dans un film de colle dans les zones prévues pour les soudures.

Ce document WO 97/34247 propose encore un mode de réalisation particulier représenté à la figure 2. Dans ce cas, il est prévu un module avec des premières plages de contact externes, lesquelles sont reliées électriquement aux secondes plages de contact affleurant une surface horizontale du logement prévu dans le corps de carte par des canaux remplis de brasure qui sont réalisés au travers du support isolant du module électronique et des premières plages de contact externe. Ce mode de réalisation pose plusieurs problèmes. Premièrement, le remplissage des canaux avec de la brasure n'est pas assuré une fois la brasure fondue. En particulier si la brasure introduite dans les canaux est initialement sous forme de pâte pour faciliter son introduction dans ces canaux, sa fusion lors de l'assemblage engendre une contraction de cette brasure et le lien matériel avec la surface latérale des trous dans les plages externes n'est pas garanti, d'autant plus que l'épaisseur des plages externes est relativement faible. Ensuite, le trou effectué dans la plage de contact externe donne à la carte un caractère inesthétique qui n'est pas compatible avec une carte de qualité. Ce risque semble confirmé par le dessin de la figure 2 du document WO 97/34247 où la brasure est en-dessous du niveau de la surface supérieure des plages externes. Il y a donc un réel problème de fiabilité. Finalement, de tels trous dans les plages externes posent un problème pour les lecteurs, lesquels possèdent généralement des patins presseurs ou des aiguilles de contact qui risquent d'être endommagés lors de l'introduction et du retrait de la carte dans ce lecteur. De plus, la brasure fondue et solidifiée (par exemple de l'étain) est généralement bien plus tendre que le métal formant les plages externes (cuivre avec un flash en or). Ainsi, si les trous des plages externes étaient remplis correctement de brasure, les patins presseurs ou les aiguilles d'un lecteur vont lors des introductions et retraits de la carte étendre la brasure sur les plages externes. Ceci a plusieurs conséquences négatives : Premièrement, la tête du lecteur est encrassée par la brasure. Deuxièmement, si la quantité de brasure étendue est relativement importante, on peut même avoir l'établissement d'un court-circuit entre deux plages de contact. Troisièmement, les plages de contact sont aussi encrassées par la brasure étendue ; ce qui est inesthétique et pas acceptable. Quoi qu'il en soit, de toute manière, on comprend que les canaux de brasure doivent nécessairement présenter un faible diamètre pour que les trous résultants dans les plages externes soient aussi petits que possible et ainsi limiter les problèmes susmentionnés. Cependant, avec de petits canaux de brasure, il est difficile d'apporter la chaleur nécessaire à une soudure jusqu'au niveau des secondes plages de contact de l'antenne.

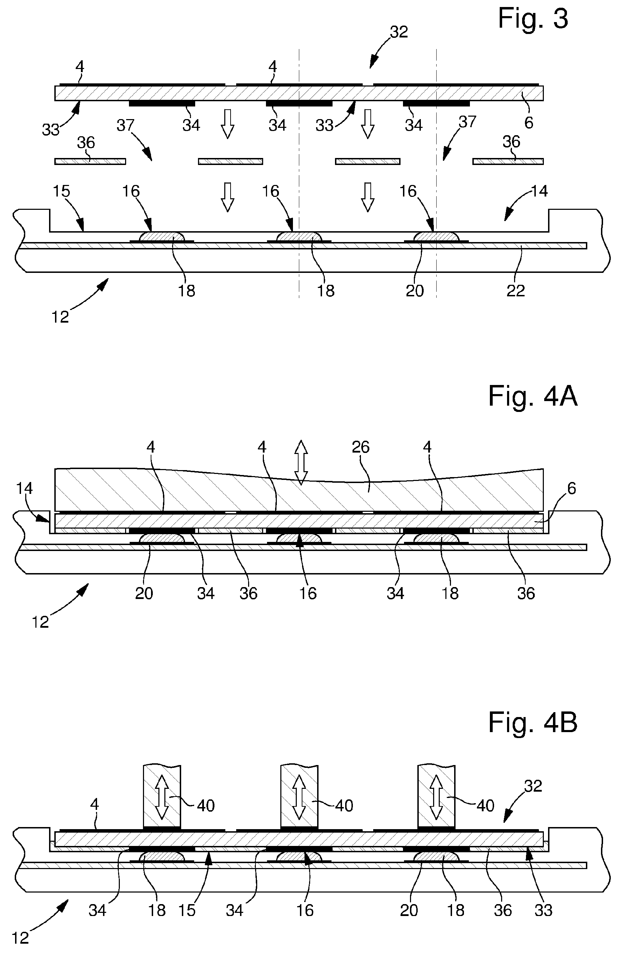

Il est aussi connu du document EP 0 818 752 un circuit électronique pour une carte à circuit intégré. Le circuit électronique comprend une feuille isolante avec, d'un premier côté, un circuit imprimé définissant notamment une antenne et, d'un deuxième côté, des plages de contact externes. Un circuit intégré est monté sur la feuille isolante du côté du circuit imprimé. Le circuit intégré est relié aux plages de contact externes par des vias traversant la feuille isolante. Ces vias peuvent être remplis de brasure. On remarquera que la Figure 4 montre un circuit électronique ('inlet') où les vias remplis de brasure traversent non seulement la feuille isolante, mais également les plages de contact des deux côtés de cette feuille isolante.

### Résumé de l'invention

Le but de la présente invention est de fournir une carte électronique avec un connecteur externe qui pallie les inconvénients de l'art antérieur tout en permettant un soudage efficace entre les plages de contact externes du connecteur et les plages de contact internes du corps de carte.

A cet effet, la présente invention concerne une carte électronique comprenant :
- un connecteur externe qui comprend un support isolant, définissant une face externe et une face interne opposées l'une à l'autre, et une pluralité de plages de contact métalliques externes qui sont agencées sur la face externe de ce support isolant;
- un corps de carte présentant un logement dans lequel le connecteur externe est agencé;
- une unité électronique et/ou une antenne incorporée(s) dans le corps de carte et reliée(s) électriquement à une pluralité de plages de contact métalliques internes qui sont agencées dans le corps de carte sous le connecteur externe ou sur une surface du logement et qui sont respectivement alignées sur la pluralité de plages de contact métalliques externes selon une direction perpendiculaire à la face externe du support isolant;
la pluralité de plages de contact métalliques externes étant respectivement reliées électriquement à la pluralité de plages de contact métalliques internes par une pluralité de parties métalliques qui sont formées chacune au moins partiellement par une brasure et qui traversent ledit support isolant par des ouvertures respectives prévues dans ce support isolant .Cette carte électronique est caractérisée en ce que la pluralité de parties métalliques sont respectivement couvertes par la pluralité de plages de contact métalliques externes qui ferment les ouvertures du support isolant du côté de sa face externe, en ce que les ouvertures du support isolant ont un diamètre supérieur à 0,2 mm (200 µm), et en ce que la majeure partie de chacune de ces ouvertures de relativement grand diamètre est remplie de métal. La pluralité de parties métalliques forment respectivement des ponts de jonction entre les surfaces arrières de la pluralité de plages de contact métalliques externes et ladite pluralité de plages de contact métalliques internes.

En particulier, les parties métalliques présentent dans les ouvertures du support isolant un diamètre suffisamment grand pour canaliser, lors de la fabrication de la carte électronique, un apport de chaleur au travers de ce support isolant qui soit suffisant pour fondre la brasure située au niveau de la face interne du support isolant ou au-dessous et réaliser ainsi un soudage du connecteur à la pluralité de plages de contact métalliques internes.

Selon une variante préférée, les parties métalliques présentent dans les ouvertures du support isolant un diamètre supérieur à 0,5 mm (500 µm).

Selon un mode de réalisation préféré, les ouvertures dudit support isolant sont au moins en majeure partie remplies de brasure.

Grâce aux caractéristiques de la carte électronique selon l'invention et en particulier du connecteur externe, les connections électriques entre ce connecteur externe et les plages de contact de l'unité électronique et/ou de l'antenne incorporée dans le corps de la carte sont effectuées au moyen de soudures robustes réalisées sans aucun dommage à l'unité électronique et sans déformation du corps de carte.

### Brève description des dessins

La présente invention sera décrite ci-après à l'aide de la description détaillée suivante, faite en référence aux dessins annexés, donnés à titre d'exemples nullement limitatifs, dans lesquels:
- les Figures 1 A et 1 B, déjà décrites, montrent schématiquement un procédé de fabrication classique de cartes électroniques de l'art antérieur;
- la Figure 2, déjà décrite, est une coupe partielle d'une carte de l'art antérieur;
- la Figure 3 montre schématiquement les divers éléments intervenant dans un premier mode de mise en oeuvre d'un procédé de fabrication avantageux pour réaliser des cartes électroniques;
- les Figures 4A et 4B montrent respectivement deux étapes du premier mode de mise en oeuvre du procédé de fabrication;
- la Figure 5 est une coupe partielle d'une carte électronique obtenue par le premier mode de mise en oeuvre du procédé de fabrication;
- la Figure 6 montre une étape d'une variante du premier mode de mise en oeuvre du procédé de fabrication;
- la Figure 7 est une coupe partielle d'une carte obtenue par la variante du procédé selon la Figure 6;
- les Figures 8A à 8E montrent schématiquement les diverses étapes d'un deuxième mode de mise en oeuvre d'un procédé de fabrication avantageux pour réaliser des cartes électroniques;
- la Figure 9 est une coupe partielle d'une carte obtenue par le deuxième mode de mise en oeuvre du procédé de fabrication;
- la Figure 10 est une vue de dessus d'un premier mode de réalisation d'un connecteur externe selon l'invention;
- la Figure 11 est une vue schématique en coupe, selon la ligne XI-XI, du connecteur externe de la Figure 10;
- la Figure 12 est une coupe partielle d'un premier mode de réalisation d'une carte électronique selon l'invention;
- la Figure 13 est une coupe partielle d'un deuxième mode de réalisation d'une carte électronique selon l'invention;
- la Figure 14 est une coupe partielle d'un deuxième mode de réalisation d'un connecteur selon l'invention;
- la Figure 15 est une coupe partielle d'un troisième mode de réalisation d'une carte électronique selon l'invention;
- la Figure 16 est une coupe partielle d'un quatrième mode de réalisation d'une carte électronique selon l'invention;
- la Figure 17 est une coupe partielle d'un troisième mode de réalisation d'un connecteur selon l'invention;
- la Figure 18 est une coupe partielle d'une variante du troisième mode de réalisation d'une carte électronique;
- la Figure 19 est une coupe partielle d'un quatrième mode de réalisation d'un connecteur selon l'invention;
- la Figure 20 est une première variante du quatrième mode de réalisation d'un connecteur;
- la Figure 21 est une variante du quatrième mode de réalisation d'une carte électronique;
- la Figure 22 est une deuxième variante du quatrième mode de réalisation d'un connecteur;
- les Figures 23A et 23B montrent deux variantes du troisième mode de réalisation d'un connecteur;
- les Figures 24A et 24B montrent deux variantes d'un cinquième mode de réalisation d'un connecteur selon l'invention;
- la Figure 25 est une coupe partielle d'un cinquième mode de réalisation d'une carte électronique selon l'invention; et
- la Figure 26 est une coupe partielle d'un sixième mode de réalisation d'une carte électronique selon l'invention.

### Description détaillée de l'invention

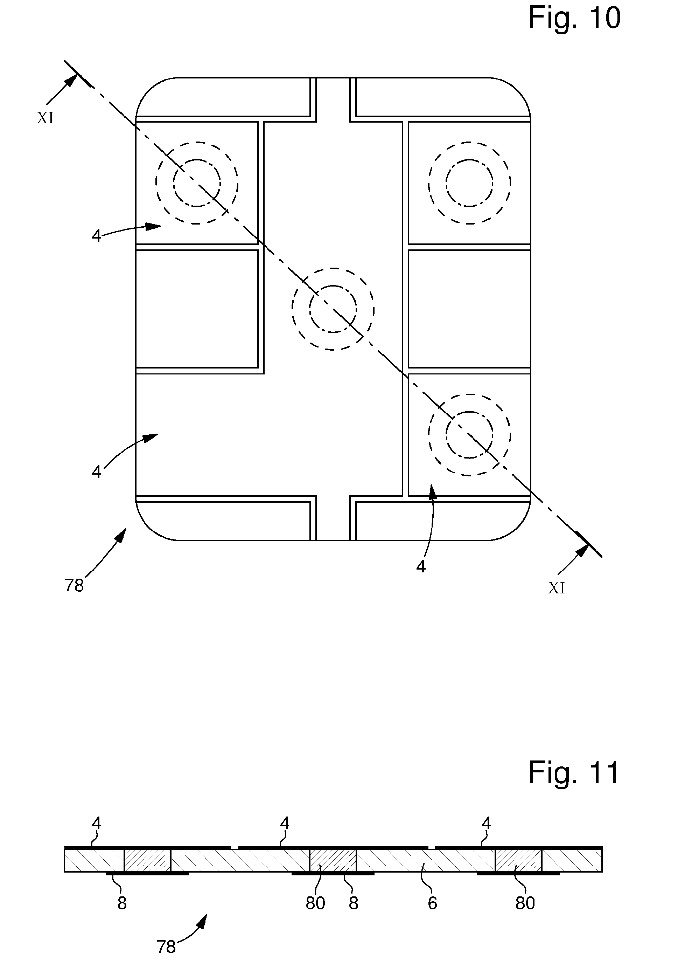

A l'aide des figures 3, 4A et 4B, on décrira un premier mode de mise en oeuvre avantageux d'un procédé de fabrication de cartes électroniques permettant de réaliser aisément des cartes électroniques selon l'invention, lesquelles seront décrites ultérieurement. Les références déjà décrites précédemment ne seront pas décrites ici à nouveau en détail. A la Figure 3 sont représentées trois éléments distincts intervenant dans la fabrication de la carte électronique. Il s'agit du connecteur externe 32, du film de colle ajouré 36 et du corps de carte 12 similaire à celui décrit précédemment. On notera ainsi que le procédé de fabrication de cartes électroniques décrit ci-après en référence aux Figures 1 à 9 n'est pas couvert par l'invention telle que revendiquée. Cependant, cet exposé est utile pour décrire un procédé permettant d'obtenir des cartes électroniques avec un connecteur externe du type de l'invention. Les cartes électroniques selon l'invention revendiquée sont décrites par la suite en référence aux Figures 10 à 26.

Le connecteur externe 32 comprend un support 6 à la face externe duquel sont agencées des plages de contact externes 4. Sur la face interne 33 du support 6 est agencée une première pluralité de plages de contact internes 34 formée de contacts métalliques dont l'épaisseur est prévue sensiblement égale à l'épaisseur du film de colle 36, par exemple entre 30 et 80 microns (30-80 µm). Ce film de colle thermocollante présente une pluralité d'ouvertures 37 dont l'agencement correspond à la première pluralité de plages de contact internes 34 du connecteur externe 32. Le corps de carte 12, dans lequel est incorporé au moins une unité électronique et/ou une antenne (non représentées sur les figures) présente une cavité 14 prévue pour le connecteur 32. A la surface 15 de cette cavité apparait une deuxième pluralité de plages de contact 16 reliées électriquement à ladite unité électronique et/ou ladite antenne incorporée dans le corps de carte.

Pour assembler le connecteur 32 au corps de carte 12, il est prévu dans une variante d'apporter un film de colle ajouré 36 qui est agencé contre la surface 15 de la cavité 14. Ensuite, le connecteur externe 32 est apporté dans la cavité avec sa face interne 33 en appui contre le film de colle 36. Les première et deuxième pluralités de plages de contact 34 et 16 sont agencées de manière à être situées l'une en face de l'autre lorsque le connecteur 32 est introduit dans la cavité 14. Le film de colle 36 est découpé sensiblement aux dimensions de la cavité 14 qui sont sensiblement ajustées à celles du support 6. Les ouvertures 37 prévues dans le film de colle 36 sont réalisées de manière à ce que ces ouvertures soient alignées sur les paires de plages de contact correspondantes 16 et 34 situées l'une en face de l'autre. Les ouvertures 37 présentent des dimensions égales ou légèrement supérieures à celles des plages de contact internes correspondantes 34. On apporte dans cette variante séparément le connecteur 32 et le film de colle 36 dans la cavité 14, la première pluralité de plages de contact 34 étant introduite dans les ouvertures 37 du film de colle. Grâce à l'agencement du connecteur et du film de colle, les plages de contact internes 34 sont alors soit en appui contre les plages de contact 16 du corps de carte 12, soit situées à très faible distance de celles-ci. A l'aide d'une presse chauffante 26, comme montré à la Figure 4A, on effectue ensuite le collage du connecteur externe 32 à la surface 15 de la cavité 14. De préférence, une pression suffisante est exercée sur le connecteur 32 pour assurer un contact physique entre les contacts métalliques 34 et les plages correspondantes 16. La cavité 14 définit ainsi un logement pour le connecteur 32 qui adhère à la surface 15 de cette cavité au moyen de la colle 36 située entre cette surface 15 et la face interne 33 du connecteur 32.

Dans une autre variante, le film de colle est agencé contre la face interne 33 du connecteur avant l'apport de ce dernier dans le logement du corps de carte. Dans cette étape préliminaire, il faut seulement s'assurer que le film de colle adhère suffisamment au connecteur pour qu'il reste solidaire de ce dernier lors de sa manipulation jusqu'à l'introduction dans son logement.

On notera ici que dans les variantes décrites, la colle prévue est apportée sous la forme d'un film de colle thermocollante. Cependant, dans d'autres variantes non décrites, cette colle peut être amenée d'autres manières, notamment sous la forme d'un liquide visqueux ou de pâte déposée dans certaines zones de la face interne 33 du support 6 ou de la surface 15 définie par le fond de la cavité 14. Toutefois, ces dernières variantes sont délicates étant donné qu'il est prévu que la colle ne recouvre pas les contacts métalliques épais 34.

Selon une variante particulière, les plages de contact internes 34 du connecteur 32 sont réalisées par un dépôt galvanique sur des plages métalliques d'un circuit imprimé sur la face interne 33 de ce connecteur. Selon une autre variante, les plages de contact internes sont réalisées par sérigraphie ou par une technologie similaire permettant de déposer précisément une brasure sous forme de pâte avec une épaisseur déterminée correspondant sensiblement à l'épaisseur du film de colle (par brasure, on comprend un métal ou une pâte métallique qui fond à une température appropriée à un soudage avec apport de matière métallique, de préférence inférieure à 1000°, c'est-à-dire un brasage). Le connecteur est avantageusement passé dans un four pour sécher cette pâte de brasure (par exemple une pâte d'étain) de sorte qu'elle durcit ou pour fondre cette pâte de manière contrôlée afin d'obtenir après solidification des plages de contact internes en métal compact (sans air et/ou liquide additionnel). Finalement, dans une autre variante, les plages de contact internes 34 sont réalisées par un dispositif de dépôt de doses de brasure, sous forme de pâte ou de préférence sous forme liquide (métal fondu), de manière localisée dans les zones prévues (en particulier sur les plages métalliques initiales d'un circuit imprimé). Dans le cas d'un apport sous forme de pâte, la surface des plages résultantes n'est pas nécessairement plane. Ici aussi le connecteur est avantageusement passé dans un four pour sécher cette pâte de sorte qu'elle durcit ou pour fondre cette pâte de brasure de manière contrôlée. Dans tous les cas, on viellera à ce que la dose de brasure présente un volume sensiblement égal à celui défini par l'ouverture prévue dans le film de colle lors de l'apport du connecteur dans la cavité du corps de carte.

Dans une autre variante non représentée, l'apport de brasure prévu pour compenser la hauteur du film de colle est effectué non sur la face interne 33 du connecteur, mais sur les plages 16 apparentes dans la cavité du corps de carte. Dans ce cas également, la dose de brasure apportée sur chaque plage 16 est déterminée pour que son volume corresponde sensiblement à celui de l'ouverture 37 correspondante du film de colle ou soit légèrement inférieur. Dans le cas où la brasure est apportée sous forme de pâte, le corps de carte est avantageusement passé dans un four pour sécher cette pâte de sorte qu'elle durcit ou pour fondre cette pâte de brasure de manière contrôlée. Les plages de contact à la face interne du connecteur sont dans la présente variante de faible hauteur (par exemple entre 5 et 10 microns, ce qui est une épaisseur classique pour un circuit imprimé).

Dans la variante décrite aux Figures 3 et 4A/4B, la deuxième pluralité de plages de contact 16 est formée par une brasure 18 déposée sur une troisième pluralité de plages de contact 20 agencée à la surface d'un support 22 associée à l'unité électronique et/ou l'antenne et incorporée dans le corps de carte 12.

Dans le cas où les plages contact externes 34 comprennent une brasure où dans l'alternative susmentionnée avec un apport de brasure sur les plages 16 du corps de carte, les plages de contact au fond de la cavité 14 peuvent être formées directement par la troisième pluralité de plages de contact 20 qui définissent alors les plages 16 affleurant la surface 15 de la cavité. Ces plages 20 peuvent présenter une certaine épaisseur obtenue notamment par un dépôt galvanique relativement épais. Chaque plage 16 peut dans une autre variante être formée par un plot ou une languette de métal, par exemple du cuivre, agencée sur la plage 20 du circuit imprimé.

Une fois le connecteur 32 collé dans la cavité 14 au moyen d'une presse chauffante 26, la colle 36 entoure les contacts métalliques épais 34. Ces contacts métalliques après l'étape de collage sont agencés contre les plages de contact 16. Il est alors prévu, comme représenté à la Figure 4B, un apport de chaleur au travers du connecteur 32 pour effectuer un soudage de la première pluralité de plages de contact 34 à la deuxième pluralité de plages de contact 16. Un tel soudage est réalisé aisément étant donné la présence de la brasure 18 et/ou d'une brasure formant au moins partiellement les contacts métalliques épais 34. De préférence, l'apport de chaleur pour le soudage est effectué de manière localisée au moyen de thermodes 40 d'un dispositif de soudage configuré pour souder simultanément l'ensemble des connexions prévues. Cet apport de chaleur localisé est effectué de manière à ne pas endommager le corps de carte 12, en particulier à éviter des déformations de celui-ci.

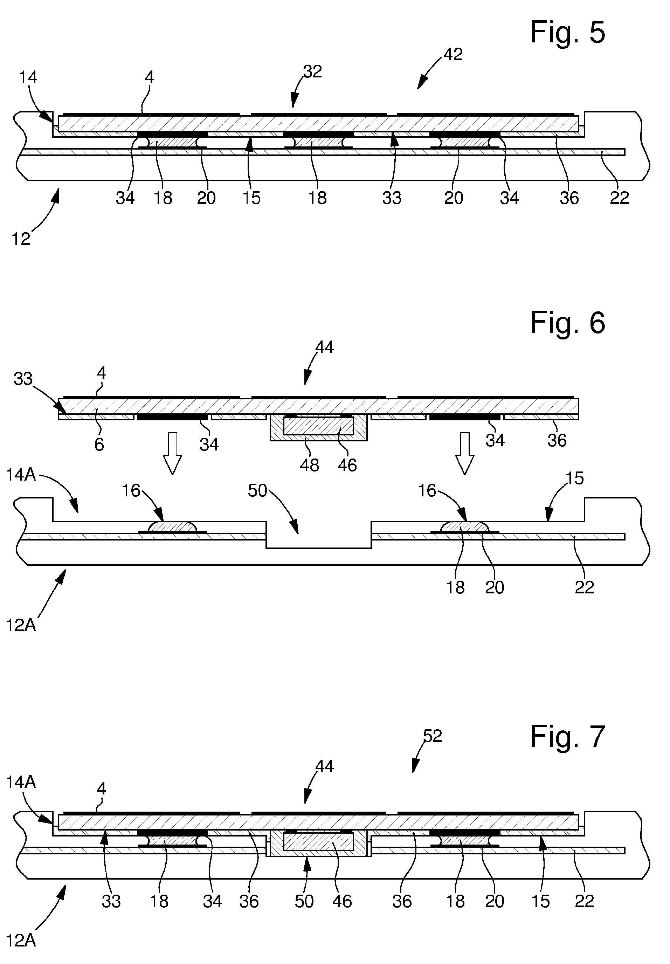

Le procédé de fabrication décrit ci-avant permet d'obtenir notamment la carte électronique 42 représentée partiellement en coupe à la Figure 5. Les plages de contact externes 4 sont reliées électriquement aux contacts métalliques épais 34. Ainsi, le connecteur externe 32 permet à un lecteur à contacts résistifs d'accéder à l'unité électronique incorporée dans la carte 42. La soudure réalisée entre chaque plage de contact interne du connecteur 32 et la plage de contact correspondante 20 agencée à la surface du support 22 garantit une connexion électrique robuste entre le connecteur externe et l'unité électronique et/ou l'antenne incorporée dans le corps 12 de la carte 42. Une telle soudure assure une forte liaison entre les plages de contact 34 et les plages de contact 20.

A la Figure 6 est représentée une variante du premier mode de mise en oeuvre du procédé décrit ci-avant et à la Figure 7 est représenté partiellement en coupe la carte électronique 52 résultant de cette variante. Les références déjà décrites précédemment ne seront pas décrites ici à nouveau en détail. Cette variante concerne un connecteur externe 44 qui comprend sur sa face interne 33 un circuit électronique 46, notamment un circuit intégré, enrobé dans une résine 48. Ce connecteur externe 44 définit ainsi un module électronique du type utilisé dans les cartes bancaires à contacts résistifs externes. En particulier, la variante de réalisation des Figures 6 et 7 concernent une carte connue sous le terme anglais "dual interface", c'est-à-dire une carte électronique pouvant communiquer avec un lecteur à contact résistif et également avec un lecteur sans contact au moyen d'une antenne agencée dans le corps de carte 12A. Ainsi, par exemple, les deux plages de contact 16 apparaissant à la surface 15 de la cavité 14A définissent deux plages de contact d'une antenne agencée sur ce support 22 et incorporée dans le corps de carte 12A. Pour permettre de loger le circuit intégré 46 et son enrobage de protection 48, la cavité 14A comprend un évidement inférieur 50 sensiblement aux dimensions de l'enrobage 48. Cet évidement 50 peut notamment traverser le support 22 comme représentées aux Figures 6 et 7. Les plages de contact internes 34 du connecteur 44 sont réalisées notamment de la même manière que celles du connecteur 32 décrit précédemment.

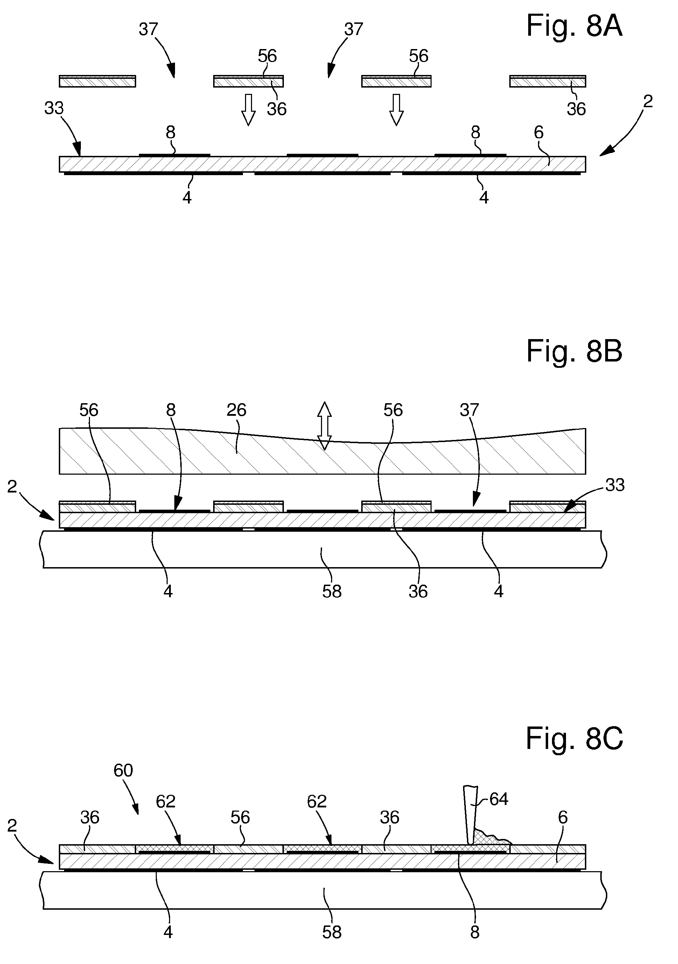

A l'aide des Figures 8A à 8E on décrira ci-après un deuxième mode de mise en oeuvre avantageux d'un procédé de fabrication de cartes électroniques permettant de réaliser aisément des cartes électronique selon l'invention qui seront décrites ultérieurement. Les références déjà décrites précédemment ne seront pas décrites ici à nouveau en détail. Dans une première étape, on apporte sur la face interne 33 d'un connecteur externe 2 un film de colle ajourée 36 présentant une pluralité d'ouvertures 37 correspondante à la pluralité de plages de contact interne 8 agencée sur cette face interne 33. Le film de colle ajouré 36 est apporté avec une feuille détachable 56 (papier siliconé) qui lui sert de support. Cette feuille détachable adhère faiblement au film de colle 36. Le film de colle 36 est posé sur la face interne 33 de manière que les plages de contact internes 8 soient situées dans les ouvertures correspondantes 37 de ce film de colle. Dans l'étape suivante, comme représenté à la Figure 8B, le film de colle 36 est appliqué contre la face interne 33 à l'aide d'une presse chauffante 26 de manière que ce film de colle 36 adhère correctement au support 6 du connecteur 2. La feuille 56 est alors enlevée.

Dans l'étape suivante représentée schématiquement à la Figure 8C, il est prévu d'apporter une brasure 62, notamment une pâte d'étain, dans les ouvertures 37 du film de colle 36. Cette brasure est apportée avec un léger excès dans les ouvertures puis, à l'aide d'une lame 64, le surplus est enlevé et les surfaces externes de la brasure 62 sont aplanies sensiblement au niveau de la surface externe du film de colle. Dans une variante particulière, la brasure est apportée par un dispositif muni d'au moins une buse, ce dispositif déposant dans chaque ouverture 37 une dose de brasure légèrement supérieure au volume défini par cette ouverture. Une fois étendue dans les ouvertures du film de colle, la pâte métallique peut ensuite être séchée dans un four. Comme le film de colle est déjà appliqué contre le connecteur, on veillera à limiter la température de séchage, par exemple entre 50° et 70°.

Une fois la brasure apportée dans les ouvertures du film de colle 36, on obtient le connecteur externe 60. Il comprend un substrat 6 sur une première face duquel sont agencées les plages de contact externes 4. Sur la seconde face du support 6 sont agencées des plages de contact 8 et le film de colle thermocollante 36 dont les ouvertures sont alignées sur les plages de contact 8. Au-dessus des plages de contact 8, dans les ouvertures du film de colle 36, est déposée une brasure 62, notamment une pâte d'étain.

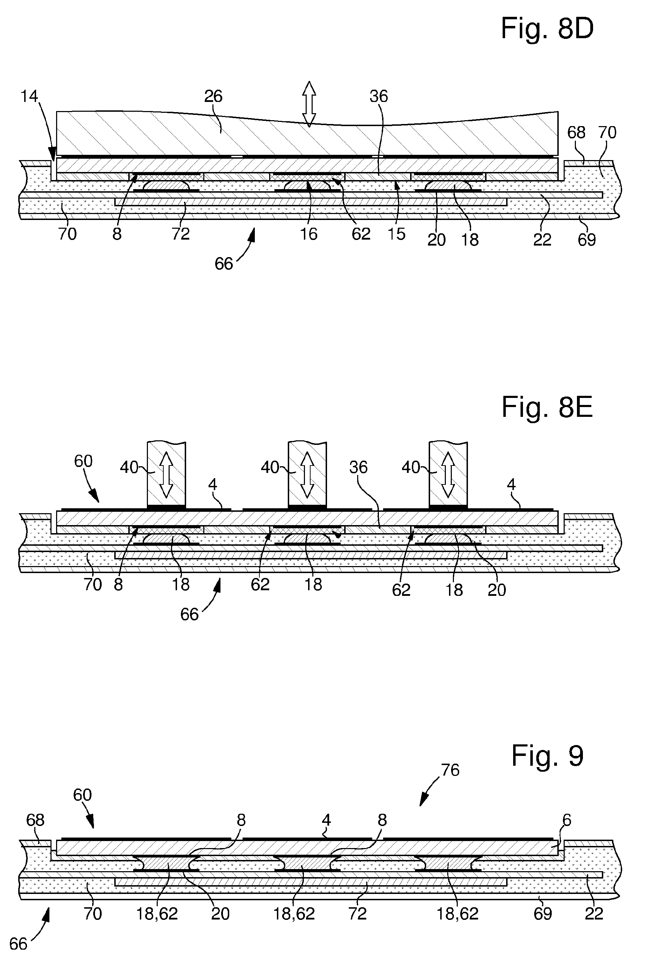

Dans une étape ultérieure du deuxième mode de mise en oeuvre du procédé de fabrication, il est prévu d'apporter le connecteur externe 60 dans une cavité 14 du corps de carte 66. Comme dans le premier mode de mise en oeuvre décrit précédemment, des plages de contact 16, formées par une brasure 18 déposée sur des plages de contact 20 internes au corps de carte 66, apparaissent à la surface du fond de la cavité. Les variantes décrites précédemment pour la réalisation des plages de contact 16 peuvent également être prévues ici. On remarquera que, dans tous les cas, la brasure nécessaire à une bonne soudure est apportée dans les ouvertures du film de colle. La pluralité de plages contact 16 est agencée de manière à être située en face de la pluralité de plages de contact internes 8 du connecteur 60. La brasure 62 déposée dans les ouvertures du film de colle 36 vient directement toucher les plages de contact 16 du corps de carte 66. Comme représenté à la Figure 8D, une presse chauffante 26 est utilisée pour activer le film de colle de manière à fixer le connecteur 60 au corps de cartes 66.

Ensuite, la presse chauffante est retirée et, dans la variante décrite ici, un dispositif de soudage comprenant une pluralité de thermodes 40 est apporté pour effectuer l'étape de soudage représentée schématiquement à la figure 8E. On remarquera que les thermodes 40 sont appliquées contre des zones des plages de contact externes 4, ces thermodes 40 étant respectivement alignées sur les paires de plages de contact correspondantes 8 et 20 entre lesquelles sont situées les brasures 18 et 62 superposées l'une à l'autre. La brasure 62 déposée localement dans les ouvertures du film de colle définit une couche intermédiaire entre les deux plages de contact de manière à compenser l'épaisseur du film de colle 36 qui est situé entre la surface du fond de la cavité dans le corps de carte et la face interne du connecteur 60 une fois ce dernier fixé au corps de carte. Les thermodes 40 apportent de manière locale une chaleur suffisante pour fondre la brasure 62 et de préférence au moins partiellement la brasure 18 entre les paires de plages de contact correspondantes. Suite à cette opération de soudage, on obtient la carte électronique représentée partiellement en coupe à la Figure 9.

Dans la variante décrite ci-avant, le collage du connecteur externe est réalisé par une presse chauffante 26 et le soudage des plages de contact internes du connecteur deux plages de contact du corps de carte est prévu dans une étape ultérieure à l'aide d'un dispositif de soudage spécifique. Dans une variante de mise en oeuvre du procédé de fabrication, il est prévu d'effectuer ces deux étapes de manière combinée à l'aide d'un dispositif capable de fournir d'une part la chaleur nécessaire au collage, lequel s'effectue par exemple entre 100 et 150°C, et d'autre part de fournir de manière localisée aux plages de contact internes du connecteur une chaleur suffisante pour effectuer le soudage prévu, par exemple à une température comprise entre 500 et 600°C.

La carte électronique 76, obtenue notamment à l'aide du deuxième mode de mise en oeuvre du procédé de fabrication, est caractérisée par une connexion de la pluralité de plages de contact internes 8 à la pluralité de plages de contact correspondantes 20 au moyen de soudures formées par les brasures 18 et 62 fondues est amalgamées de manière à former des ponts métalliques rigides entre les paires de plages de contact correspondantes. Les brasures 18 et 62 sont formées de préférence d'étain; mais dans d'autres variantes, la soudure peut également être réalisée par exemple avec du cuivre.

Le corps de carte 66 est formé d'une couche intermédiaire de résine 70 située entre deux couches externes 68 et 69. Le support 22, à la surface duquel sont agencées les plages de contact 20 et les gouttes de brasure 18, est enrobée par la résine 70. Cette résine 70 enrobe également d'autres éléments de la carte en fabrication, notamment l'unité électronique et/ou l'antenne (non représentées) incorporées dans la carte électronique. Selon une variante de réalisation préférée, il est prévu au dos du support 22 d'agencer une couche solide 72 dont la fonction est de positionner en hauteur le support 22 et donc les bosses de brasure 18 dans la couche intermédiaire de résine. Ceci permet d'assurer que les plages de contact 16, définies par les bosses de brasure tronquées, affleurent la surface du fond de la cavité lors de l'usinage ce cette cavité. En effet, on comprend que la profondeur de la cavité est définie par l'épaisseur du connecteur externe. Dans le cas d'une fabrication à l'aide d'une résine 70 apportée dans un état non solide, notamment liquide visqueux ou pâteux, il a été observé que le substrat 22 a une tendance de descendre dans la résine et reste alors relativement proche de la couche solide inférieure 69. Ceci pose un problème notamment dans la fabrication de cartes complexes utilisant des résines apportées dans un état non solide pour enrober les divers éléments et unités prévus. Grâce à la couche solide additionnelle 72 prévue au dos du support 22, il est possible de positionner de manière relativement précise dans l'épaisseur de la couche de résine le support 22 et donc les bosses de brasure s'élevant des plages de contact 20.

Un procédé de fabrication particulier d'une carte électronique, comprenant au moins une unité électronique et/ou une antenne incorporée dans le corps de cette carte et des plages de contact externes, comprend les étapes suivantes:
- fabrication d'un connecteur externe présentant à sa face externe lesdites plages de contact externes et à sa face interne, opposée à la face externe, une pluralité de plages de contact internes;
- fabrication du corps de carte avec une cavité prévue pour le connecteur, l'unité électronique et/ou l'antenne étant reliées électriquement à une deuxième pluralité de plages de contact apparaissant à une surface de la cavité prévue dans le corps de la carte;
- apport du connecteur et d'une colle dans la cavité, les première et deuxième pluralités de plages de contact étant agencées de manière à être situées l'une en face de l'autre lorsque ce connecteur est introduit dans la cavité;
- apport de chaleur au travers du connecteur pour effectuer un soudage de la première pluralité de plages de contact à la deuxième pluralité de plages de contact, les plages de contact de la première pluralité et/ou les plages de contact de la deuxième pluralité étant configurées et/ou une brasure intermédiaire étant localement déposée sur la première et/ou la deuxième pluralité de plages de contact de manière à compenser l'épaisseur de la colle située entre la surface de la cavité et la face interne du connecteur une fois ce dernier fixé au corps de la carte.

Aux Figures 10 et 11 est représenté de manière schématique un premier mode de réalisation d'un connecteur externe selon l'invention. Ce connecteur 78 présente de manière classique des plages de contact externes 4 sur la face externe du support 6 et des plages de contact internes 8 sur la face interne de ce support 6. Selon l'invention, des vias métalliques 80 de relativement grand diamètre sont prévus entre les plages de contact externes 4 et les plages de contact internes 8. Ces vias métalliques servent premièrement à la connexion électrique des plages externes 4 aux plages internes 8. Ensuite, ces vias 80 superposés aux plages de contact internes 8 favorisent l'étape de soudage de ces plages de contact aux plages de contact correspondantes du corps de carte, comme décrit précédemment. En effet, ce substrat 6 est formé d'un matériau isolant qui généralement conduit mal la chaleur. Par contre, les vias métalliques 80 conduisent très bien la chaleur. Ainsi, la chaleur apportée au moyen du dispositif de soudage spécifique décrit précédemment est canalisée par les vias 80 en direction des plages de contact internes 8 et de la brasure prévue au niveau ou en-dessous de celles-ci pour effectuer le soudage aux plages de contact internes du corps de carte. Grâce à l'agencement de vias 80, tel que représenté schématiquement à la figure 11, il est ainsi possible d'apporter moins de chaleur lors l'étape de soudage et donc d'éviter des déformations locales du corps de carte dû à cet apport de chaleur, lequel engendre des températures élevées pour les matériaux plastiques ou la résine formant le corps de carte.

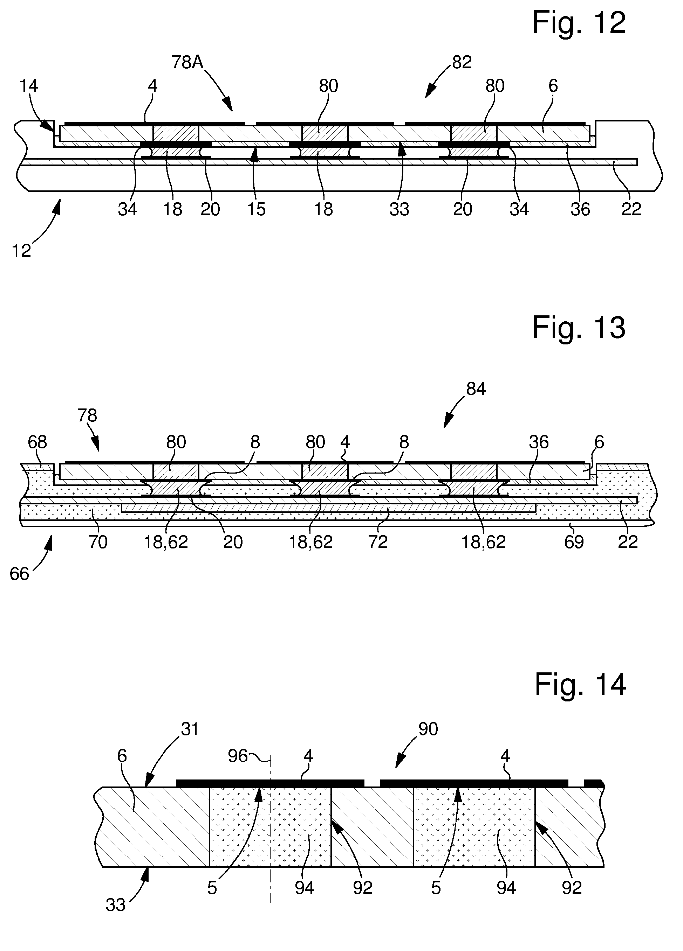

A la Figure 12 est représenté schématiquement en coupe un premier mode de réalisation d'une carte électronique 82 selon l'invention. Cette carte comprend un connecteur 78A selon l'invention, similaire au connecteur 78 décrit ci-dessus et présentant une plage de contact épaisse 34. Elle est obtenue avec le premier mode du procédé de fabrication décrit précédemment. On remarquera que chaque via 80 et la plage 34 associée peuvent être formées d'un même matériau et former ainsi ensemble un même élément. A la Figure 13 est représentée schématiquement en coupe une carte électronique 82 selon un deuxième mode de réalisation d'une carte selon l'invention. Cette carte comprend le connecteur 78 décrit aux Figures 10 et 11 et elle est obtenue avec le deuxième mode du procédé de fabrication décrit précédemment. Les plages de contact 8 peuvent être définies par les surfaces inférieures des vias 80. Ainsi, dans les cartes des Figures 12 et 13 obtenues avec un connecteur selon le premier mode décrit ci-avant, la pluralité de plages de contact métalliques externes 4 sont respectivement reliées électriquement à la pluralité de plages de contact métalliques internes 20 par une pluralité de parties métalliques 18+34+80, respectivement 18,62+8+80 qui sont formées chacune au moins partiellement par une brasure et qui traversent le support isolant 6 par des ouvertures respectives prévues dans ce support isolant. La carte électronique 82, 84 selon l'invention est caractérisée par le fait que la pluralité des parties métalliques sont respectivement couvertes par la pluralité de plages de contact métalliques externes 4 qui ferment les ouvertures du support isolant 6 du côté de sa face externe, cette pluralité de parties métalliques formant respectivement des ponts de jonction entre les surfaces arrières de la pluralité de plages de contact métalliques externes 4 et la pluralité de plages de contact métalliques internes 20. En plus des variantes déjà mentionnées pour obtenir des plages de contact épaisses 34 et pour réaliser les soudures prévues entre des plages de contact internes du connecteur et des plages de contact correspondantes agencées à une surface de la cavité formant logement pour ce connecteur, divers modes de réalisation avantageux et des variantes spécifiques de la présente invention seront décrits ci-après.

La Figure 14 montre un deuxième mode de réalisation d'un connecteur 90 selon l'invention. Le support isolant 6 présente des ouvertures 92 qui sont fermées du côté de la face externe 31 par des plages de contact métalliques externes 4. Chaque ouverture 92 est remplie d'une pâte de brasure 94 sensiblement jusqu'au niveau de la face interne 33 du support isolant, cette brasure étant déposée sur la surface arrière 5 des plages 4. Les ouvertures ont un axe central 96 perpendiculaire à la face externe 31 et donc au plan défini par les plages 4. Ces plages 4 sont de préférence réalisées avec un film ou une feuille métallique (notamment du cuivre) déposé sur la face externe 33 du support 6. Elles présentent une certaine rigidité qui est suffisante pour rester plane au-dessus des ouvertures du support isolant, également lors de l'apport de chaleur pour effectuer le soudage prévu. On notera que seulement une ou deux plage(s) externe(s) est/sont représentée(s) entièrement à la Figure 14 et aux Figures suivantes, mais le connecteur peut présenter plusieurs plages de contact externes, notamment deux rangées de trois ou quatre plages.

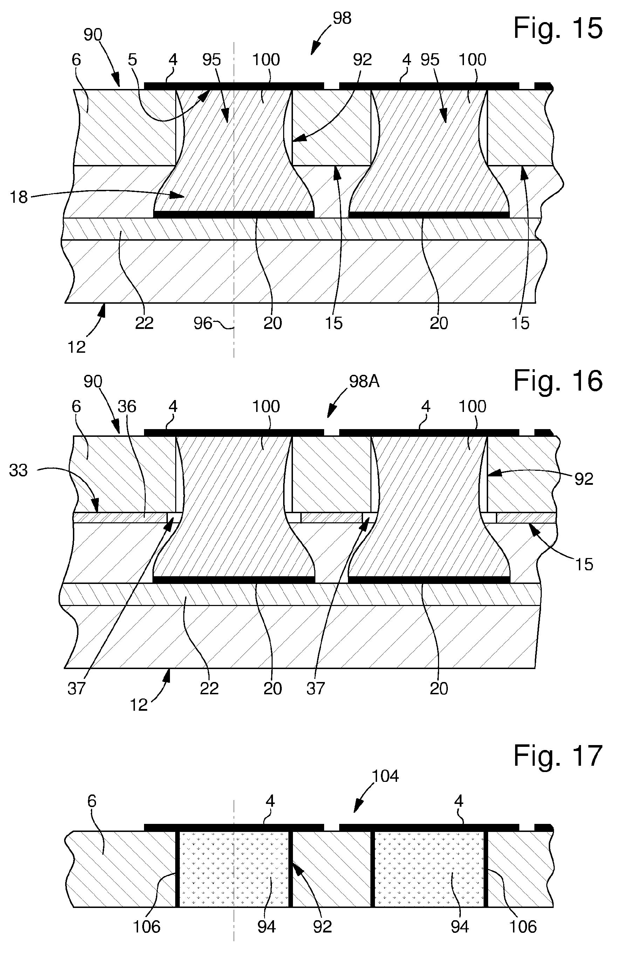

La Figure 15 montre un troisième mode de réalisation d'une carte 98 selon l'invention. Cette carte comprend un corps de carte 12 du type décrit précédemment qui comprend des plages de contact métalliques internes 20 généralement agencées sur un support isolant 22. Dans la cavité de ce corps de carte est logé le connecteur 90, sans film de colle entre ce dernier et la surface 15 de la cavité. Les plages internes 20 sont agencées sous ledit connecteur externe et respectivement alignées sur les plages externes 4 selon la direction 96 perpendiculaire à la face externe 31. Lors de la fabrication de la carte 98, comme exposé précédemment, on apporte de manière localisée sur les plages externes 4 de la chaleur pour effectuer une connexion soudée. Cette chaleur est directement transmise à la pâte de brasure 94 qui est posée sur la surface arrière 5 des plages externes. Avec un apport contrôlé de chaleur, la brasure dans chaque ouverture 92 fond et la chaleur arrive aisément au travers de cette brasure à la bosse de brasure 18 située en regard de l'ouverture 92 correspondante et déposée sur la plage interne 20. Cette brasure 18 fond au moins en surface et se lie avec la brasure 94 en fusion, laquelle après refroidissement forme une brasure 95 avec un volume légèrement inférieur dû à sa contraction. Il apparait ainsi de petits vides entre la brasure 95 et la surface latérale des ouvertures 92, comme montré schématiquement à la Figure 15. Au final, la carte 98 a une pluralité de plages externes 4 respectivement reliées électriquement une pluralité de plages internes 20 par une pluralité de parties métalliques 100 qui sont formées chacune au moins partiellement par une brasure et qui traversent le support isolant 6 par des ouvertures respectives 92 prévues dans ce support isolant. Dans la variante représentée, les parties métalliques 100 sont entièrement formées de brasure.

La Figure 16 montre une carte électronique 98A selon un quatrième mode de réalisation de l'invention. Cette carte se distingue de celle de la Figure 15 par le fait que le connecteur, en plus d'être soudé au corps de carte, est collé sur la surface 15 de la cavité où il est logé. En utilisant le connecteur tel que représenté à la Figure 14, on comprend qu'il y a un déficit de brasure dans les ouvertures 37 du film de colle 36 utilisé. Cependant, lors de la fusion de la brasure 94, cette dernière coule en direction de la brasure 18 et la soudure traverse alors aussi les ouvertures du film de colle. On notera que d'autres connecteurs selon l'invention décrits par la suite peuvent être avantageusement utilisés.

Dans tous les dessins de cartes selon l'invention, des bosses de brasure 18 sont déposées sur les plages internes 20, ces bosses étant à l'intérieur du corps de carte et présentant généralement une surface supérieure tronquée lors de l'usinage de la cavité, lesquelles définissent initialement des plages de contact intermédiaires. Cependant les cartes selon la présente invention ne se limitent pas à un tel agencement. En effet, dans d'autres variantes non représentées, les plages internes 20 peuvent chacune directement affleurer une surface de la cavité réalisée dans le corps de carte et la soudure prévue est effectuée de préférence avec la brasure que contient le connecteur sous ses plages externes. On notera encore que la brasure, dans d'autres variantes de fabrication, peut être déposée, préalablement à l'apport du connecteur, sur les plages internes lorsqu'elles sont apparentes dans la cavité ou sinon sur les bosses de brasure 18. On comprend que les ouvertures 92 du connecteur peuvent être partiellement remplies de brasure, voire être vides lors de l'apport de ce connecteur dans la cavité, la brasure déposée sur les plages apparentes dans la cavité remplissant alors au moins partiellement les ouvertures du support isolant. Le dosage est effectué de manière que la brasure dans ces ouvertures soit en contact avec la surface arrière des plages externes 4. On peut ainsi également obtenir après le soudage une carte selon l'invention.

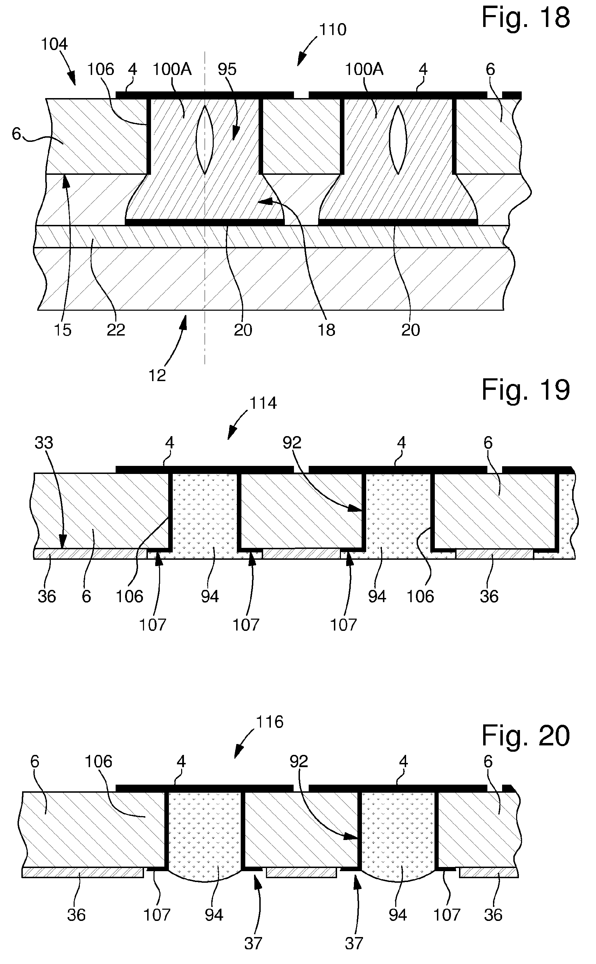

La Figure 17 montre un connecteur 104 selon un troisième mode de réalisation. Il se distingue de celui de la Figure 14 par le fait que la paroi latérale des ouvertures 92 est recouverte d'une couche métallique 106 adhérant correctement à cette paroi latérale. Cette couche 106 définit une couche d'accrochage pour la pâte de brasure 94 en fusion. Elle comprend avantageusement un flash d'or supérieur, lequel recouvre aussi de préférence la surface arrière des plages de contact externes. Ainsi, lors du soudage prévu, la brasure fondue 95 se lie aisément à cette couche métallique et à la face arrière des plages externes. On obtient alors des parties métalliques 100A avec de l'air et/ou un liant résiduel situé plutôt à l'intérieur de ces parties métalliques, comme représenté schématiquement à la Figure 18 qui est une variante du troisième mode de réalisation d'une carte 110 selon l'invention.

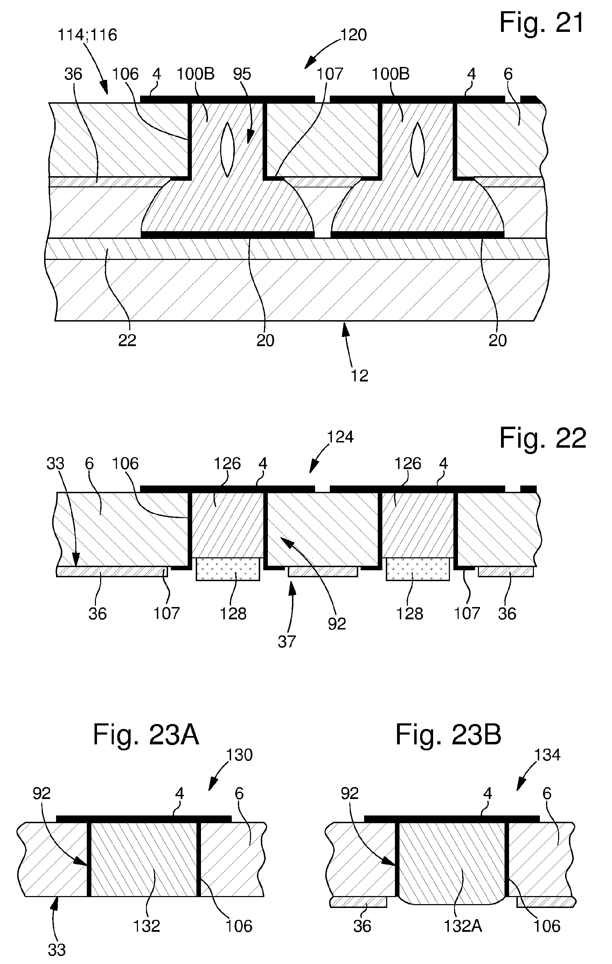

La Figure 19 montre un connecteur 114 selon un quatrième mode de réalisation. Il se distingue par le fait que la métallisation 106 se prolonge à la périphérie de chaque ouverture 92 par une couche métallique 107 de même constitution. Les trous 92 étant normalement circulaires, la couche 107 définit généralement une plage de contact annulaire. Un film de colle 36 est appliqué contre la face interne 33 du support isolant. Il présente des ouvertures alignées chacune sur les ouvertures correspondantes du support 6 avec un diamètre correspondant sensiblement au diamètre externe de la couche 107. Comme dans le cas du deuxième mode de fabrication décrit précédemment, la brasure 94, en plus de remplir les ouvertures 92, remplit les ouvertures du film de colle. La brasure peut être apportée ici avec un petit surplus qui est enlevé avec une lame, comme représenté à la Figure 8C. On remarquera que les connecteurs 90, 104 et 114 décrits ci-avant peuvent avantageusement être passés dans un four pour sécher la pâte de brasure avant leur assemblage au corps de carte. La Figure 20 montre une première variante dans laquelle la brasure 94 est apportée par un dispositif-doseur qui dépose dans chaque ouverture 92 du connecteur 116 une dose précise qui est supérieure au volume de l'ouverture 92, de manière à remplir au moins partiellement l'ouverture correspondante du film de colle lors de l'introduction du connecteur dans la cavité du corps de carte et à recouvrir de préférence la plage de contact annulaire 107. A noter que dans ce cas-ci, le film de colle peut être apporté séparément du connecteur dans la cavité correspondante du corps de carte. Après introduction du connecteur 114 ou 116 dans cette cavité et apport de chaleur pour effectuer le soudage prévu, on obtient une carte 120 telle que représentée schématiquement à la Figure 21. Cette carte présente une partie métallique 100B entre les plages externes 4 et les plages internes 20 qui épouse essentiellement la forme définie par les ouvertures 92 et 37 (Figure 20).

A la Figure 22 est représenté schématiquement un connecteur 124 qui définit une deuxième variante du connecteur 114. Ce connecteur se distingue par le fait que la brasure apportée dans les ouvertures 92 se présente sous deux formes, une première partie 126 sous forme de métal compact, c'est-à-dire fondue et durcie, et une deuxième partie 128 sous forme de pâte. Dans l'exemple représenté, une brasure sous forme de pâte est premièrement introduite dans les ouvertures 92. Ensuite, les connecteurs sont passés dans un four et la pâte fond en se contractant de sorte que la brasure 126 ne remplit pas les ouvertures 92. Une pâte de brasure 128 est ensuite apportée par une technique de sérigraphie avec une épaisseur suffisante pour que cette pâte atteigne au moins la surface externe du film de colle 36. Une petite surépaisseur, comme dans le cas de la Figure 19, est avantageusement prévue pour remplir au mieux l'ouverture 37 lors du placement du connecteur dans un logement lors de la fabrication d'une carte selon l'invention, et pour assurer dès avant la fusion de la pâte de brasure un contact entre celle-ci et une plage de contact affleurant une surface du fond du logement.

Aux Figures 23A, 23B sont respectivement représentées deux variantes du troisième mode de réalisation d'un connecteur. Ces variantes peuvent aussi être prévues dans le cadre du deuxième ou quatrième mode de réalisation. Elles se distinguent essentiellement en ce que les ouvertures 92 sont remplies de brasure 132 sous forme de métal compact, c'est-dire d'une brasure ayant été fondue pour remplir ces ouvertures et ensuite durcie en refroidissant. On peut soit apporter de la pâte de brasure puis la fondre, soit apporter directement avec un doseur de la brasure liquide qui se durcit ensuite dans les ouvertures. Ce dernier cas demande un dispositif plus complexe. Dans le cas de l'apport de pâte de brasure, pour remplir les ouvertures 92, on peut prévoir un remplissage en deux étapes dans chacune desquelles une pâte de brasure est déposée dans les ouvertures puis fondue. Le connecteur 130 présente des ouvertures 92 sensiblement remplies de brasure jusqu'au niveau de la face interne 33, alors que le connecteur 134 présente des plots de brasure 132 dont la surface supérieure est quasi au niveau de la surface externe du film de colle 36. Ce dernier peut être collé préalablement sur la face interne 33 du connecteur après la formation du plot de brasure 132A ou être apporté dans la cavité du corps de carte avant ou simultanément à l'apport du connecteur. Les plots de brasure 132 et 132A définissent des vias métalliques de relativement grand diamètre. Ce diamètre est supérieur à 200 microns et de préférence supérieur à 500 microns. La hauteur de ces plots varie en fonction de l'épaisseur du support isolant 6, par exemple entre 150 et 250 microns. Contrairement à un via électrique classique qui est de petit diamètre (généralement d'environ 100 microns ou moins) ou vide dans sa partie centrale lorsque ce diamètre augmente, les plots ou vias selon l'invention ont un relativement grand diamètre et sont massifs, la majeure partie des ouvertures du support isolant étant remplie de métal.

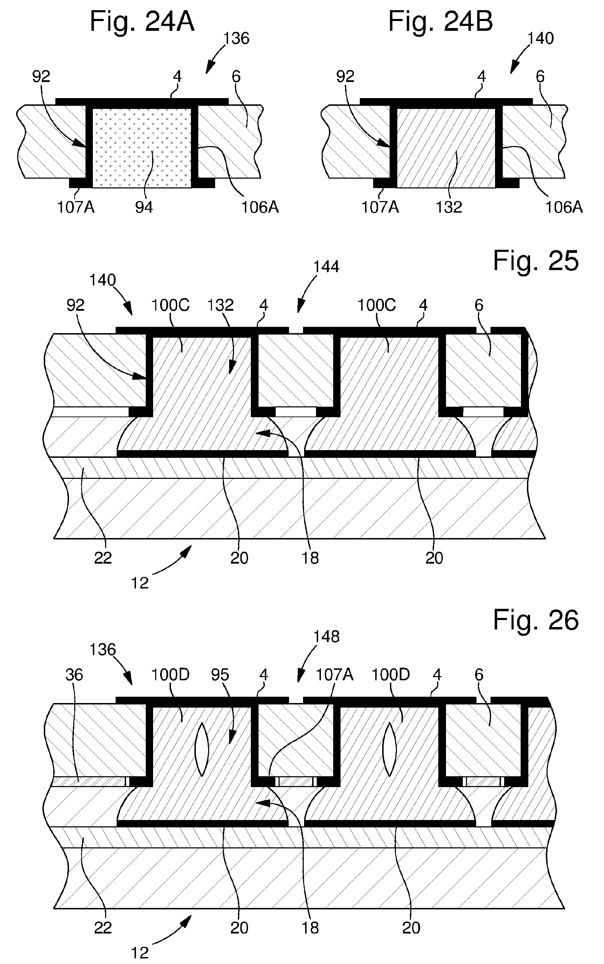

Aux Figures 24A et 24B sont représentées deux variantes d'un cinquième mode de réalisation d'un connecteur particulièrement avantageux. Ce mode s'apparente au quatrième mode décrit précédemment mais s'en distingue par le fait que la couche métallique périphérique 107A présente une épaisseur relativement importante qui est sensiblement égale ou supérieure à 30 microns (30µm), par exemple entre 30 et 70 microns, et de préférence sensiblement égale à l'épaisseur de la couche de colle dans le cas où elle est prévue. Les couches métalliques minces des Figures 19 et 20 peuvent être déposées sous vide par diverses technologies connues de l'homme du métier. Elles peuvent notamment comprendre plusieurs sous-couches pour améliorer la fonction d'interface d'adhésion. Les couches métalliques épaisses sont formées de préférence par un premier dépôt d'au moins une couche mince par une technique de dépôt sous vide, par exemple par évaporation, puis par un dépôt galvanique permettant d'obtenir aisément l'épaisseur désirée. Un flash d'or terminal peut être prévu. Dans ce cas, la couche 106A recouvrant la paroi latérale des ouvertures 92 est aussi relativement épaisse bien qu'elle puisse être de moindre épaisseur. Les surfaces arrières des plages externes fermant les ouvertures sont généralement aussi recouvertes d'une couche de même nature. Le connecteur 136 a les trous borgnes définis par la couche métallique 106A+107A rempli de pâte de brasure 94 sensiblement jusqu'au niveau du haut le la couche périphérique 107A, alors que le connecteur 140 a ces trous borgnes remplis d'une brasure 132.

A la Figure 25 est représenté un cinquième mode de réalisation d'une carte selon l'invention. Cette carte 144 est formée d'un corps de carte 12 et du connecteur 140 de la Figure 24B. Aucun film de colle n'est prévu ici. Les soudures effectuées au niveau de chaque plage externe servent à établir un contact électrique fiable et également à fixer le connecteur dans la cavité. La partie métallique 100C est entièrement pleine et compacte. Dans une variante on prend le connecteur 136 de la Figure 24A. A la Figure 26 est représenté un sixième mode de réalisation d'une carte selon l'invention. Cette carte 148 est formée d'un corps de carte 12 et du connecteur 136 de la Figure 24A. Comme expliqué précédemment, la pâte de brasure en fondant se contracte un peu en laissant apparaître au moins un espace d'air ou de liant dans la partie métallique 100D obtenue. Dans ce cas-ci, une couche de colle 36 d'une épaisseur sensiblement égale à celle des plages périphériques 107A est agencée entre le support isolant et le fond de la cavité. Dans une variante on prend le connecteur 140.

On notera finalement que la technique de l'invention pour obtenir des plages de contact externes d'un connecteur externe soudées à des plages de contact internes d'un corps de carte peut être aussi utilisées pour effectuer des points de soudure supplémentaires entre le connecteur et le corps de cartes sans fonction électrique, de manière à améliorer la fixation de ce connecteur au corps de carte et notamment éviter l'apport d'un film de colle.

## Revendications

1. Carte électronique (82; 84; 98, 98A ; 110 ; 120 ; 144, 148) comprenant :
- un connecteur externe (78 ; 78A ; 90 ; 104 ; 114 ; 116 ; 136, 140) qui comprend un support isolant (6), définissant une face externe (31) et une face interne (33) opposées l'une à l'autre, et une pluralité de plages de contact métalliques externes (4) qui sont agencées sur ladite face externe de ce support isolant;
- un corps de carte (12 ; 66) présentant un logement (14) dans lequel ledit connecteur externe est agencé;
- une unité électronique et/ou une antenne incorporée(s) dans ledit corps de carte et reliée(s) électriquement à une pluralité de plages de contact métalliques internes (20) qui sont agencées dans le corps de carte, sous ledit connecteur externe, ou sur une surface dudit logement et qui sont respectivement alignées sur la pluralité de plages de contact métalliques externes selon une direction perpendiculaire à ladite face externe;
ladite pluralité de plages de contact métalliques externes étant respectivement reliées électriquement à la pluralité de plages de contact métalliques internes par une pluralité de parties métalliques (18, 34, 80 ; 18, 62, 8, 80 ; 100, 100A, 100B 100C, 100D) qui sont formées chacune au moins partiellement par une brasure (18 ; 62 ; 95 ; 132) et qui traversent ledit support isolant par une pluralité d'ouvertures respectives (92) prévues dans ce support isolant;
cette carte électronique étant **caractérisée en ce que** ladite pluralité de parties métalliques sont respectivement couvertes par la pluralité de plages de contact métalliques externes qui ferment ladite pluralité d'ouvertures du support isolant du côté de sa face externe, la pluralité de parties métalliques formant respectivement des ponts de jonction entre les surfaces arrières (5) de la pluralité de plages de contact métalliques externes et ladite pluralité de plages de contact métalliques internes, **en ce que** lesdites ouvertures dudit support isolant ont un diamètre supérieur à 0,2 mm (200 µm), et **en ce que** la majeure partie de chacune de ces ouvertures de relativement grand diamètre est remplie de métal..

2. Carte électronique selon la revendication 1, **caractérisée en ce que** lesdites parties métalliques présentent dans lesdites ouvertures dudit support isolant un diamètre suffisamment grand pour canaliser, lors de la fabrication de la carte électronique, un apport de chaleur au travers de ce support isolant qui soit suffisant pour fondre ladite brasure située au niveau de ladite face interne du support isolant ou au-dessous et réaliser ainsi un soudage dudit connecteur à la pluralité de plages de contact métalliques internes.

3. Carte électronique selon la revendication 1 ou 2, **caractérisée en ce que** ladite pluralité d'ouvertures (92) dudit support isolant ont chacune un diamètre supérieur à 0,5 mm (500 µm).

4. Carte électronique selon l'une des revendications précédentes, **caractérisée en ce que** ladite pluralité d'ouvertures (92) sont remplies sensiblement entièrement de métal dont au moins la majeure partie est formée par une brasure.

5. Carte électronique selon la revendication 4, **caractérisée en ce que** ladite pluralité d'ouvertures du support isolant (6) ont leur paroi latérale recouverte d'une couche métallique (106, 106A) formant une interface d'adhésion pour ladite brasure située dans ces ouvertures.

6. Carte électronique selon l'une quelconque des revendications précédentes, **caractérisée en ce que** des plages métalliques périphériques (107), entourant respectivement les ouvertures de ladite pluralité d'ouvertures du support isolant, sont agencées sur ladite face interne dudit support isolant.

7. Carte électronique selon l'une quelconque des revendications précédentes, **caractérisée en ce qu'**un film de colle (36), présentant des ouvertures respectivement alignées sur les ouvertures de ladite pluralité d'ouvertures du support isolant, est agencé entre ladite face interne dudit support isolant et une surface dudit logement située en regard de cette face interne.

8. Carte électronique selon la revendication 6, **caractérisé en ce que** lesdites plages métalliques périphériques ont une épaisseur sensiblement égale ou supérieure à 30 microns (30µm).

9. Carte électronique selon la revendication 7, **caractérisé en ce que** les ouvertures du film de colle ont un plus grand diamètre que celui de ladite pluralité d'ouvertures du support isolant.

10. Carte électronique selon la revendication 7 ou 9, **caractérisé en ce que** de la brasure est située dans chaque ouverture desdites ouvertures dudit film de colle.

## Patentansprüche

1. Elektronische Karte (82; 84; 98, 98A; 110; 120; 144; 148), umfassend:
- einen äußeren Anschluss (78; 78A; 90; 104; 114; 116; 136, 140), der einen isolierenden Träger (6), der eine äußere Fläche (31) und eine gegenüberliegende innere Fläche (33) definiert, und mehrere äußere metallische Kontaktbereiche (4), die auf der äußeren Fläche dieses isolierenden Trägers angeordnet sind, enthält;
- einen Kartenkörper (12; 66), der einen Aufnahmeraum (14) aufweist, in dem der äußere Anschluss angeordnet ist;
- eine elektronische Einheit und/oder eine Antenne, die in den Kartenkörper eingebaut sind und mit mehreren inneren metallischen Kontaktbereichen (20) elektrisch verbunden sind, die in dem Kartenkörper unter dem äußeren Anschluss oder auf einer Oberfläche des Aufnahmeraums angeordnet sind und jeweils in einer Richtung senkrecht zu der äußeren Oberfläche auf die mehreren äußeren metallischen Kontaktbereiche ausgerichtet sind;
wobei die mehreren äußeren metallischen Kontaktbereiche jeweils mit den mehreren inneren metallischen Kontaktbereichen durch mehrere metallische Teile (18, 34, 80; 18, 62, 8, 80; 100, 100A, 100B, 100C, 100D) elektrisch verbunden sind, die jeweils wenigstens teilweise durch ein Lötmittel (18; 62; 95; 132) gebildet sind und durch den isolierenden Träger durch mehrere entsprechende Öffnungen (92), die in diesem isolierenden Träger vorgesehen sind, verlaufen;
wobei diese elektronische Karte **dadurch gekennzeichnet ist, dass** die mehreren metallischen Teile jeweils durch die mehreren äußeren metallischen Kontaktbereiche abgedeckt sind, die die mehrere Öffnungen des isolierenden Trägers auf Seiten seiner äußeren Fläche verschließen, wobei die mehreren metallischen Teile jeweils Verbindungsbrücken zwischen den hinteren Oberflächen (5) der mehreren äußeren metallischen Kontaktbereiche und den mehreren inneren metallischen Kontaktbereichen bilden, dass die Öffnungen des isolierenden Trägers einen Durchmesser von mehr als 0,2 mm (200 µm) besitzen und dass der größte Teil jeder dieser Öffnungen mit verhältnismäßig großem Durchmesser mit Metall gefüllt ist.

2. Elektronische Karte nach Anspruch 1, **dadurch gekennzeichnet, dass** die metallischen Teile in den Öffnungen des isolierenden Trägers einen Durchmesser aufweisen, der ausreichend groß ist, um bei der Fertigung der elektronischen Karte einen Wärmeeintrag durch diesen isolierenden Träger zu kanalisieren, der ausreicht, um das Lötmittel, das sich auf Höhe der inneren Fläche des isolierenden Trägers oder darunter befindet, zu schmelzen und somit ein Verschweißen des Anschlusses mit den mehreren inneren metallischen Kontaktbereichen zu verwirklichen.

3. Elektronische Karte nach Anspruch 1 oder 2, **dadurch gekennzeichnet, dass** die mehreren Öffnungen (92) des isolierenden Trägers jeweils einen Durchmesser besitzen, der größer als 0,5 mm (500 µm) ist.

4. Elektronische Karte nach einem der vorhergehenden Ansprüche, **dadurch gekennzeichnet, dass** die mehreren Öffnungen (92) im Wesentlichen vollständig mit Metall, wovon der größte Teil durch ein Lötmittel gebildet ist, gefüllt sind.

5. Elektronische Karte nach Anspruch 4, **dadurch gekennzeichnet, dass** die jeweilige Seitenwand der mehreren Öffnungen des isolierenden Trägers (6) mit einer Metallschicht (106, 106A) beschichtet ist, die eine Haftgrenzfläche für das Lötmittel, das sich in diesen Öffnungen befindet, bildet.

6. Elektronische Karte nach einem der vorhergehenden Ansprüche, **dadurch gekennzeichnet, dass** die metallischen Umfangsbereiche (107), die die jeweiligen Öffnungen der mehreren Öffnungen des isolierenden Trägers umgeben, auf der Innenfläche des isolierenden Trägers angeordnet sind.

7. Elektronische Karte nach einem der vorhergehenden Ansprüche, **dadurch gekennzeichnet, dass** zwischen der inneren Fläche des isolierenden Trägers und einer Oberfläche des Aufnahmeraums, die sich gegenüber dieser Fläche befindet, ein Klebstofffilm (36) angeordnet ist, der Öffnungen aufweist, die jeweils auf die Öffnungen der mehreren Öffnungen des isolierenden Trägers ausgerichtet sind.

8. Elektronische Karte nach Anspruch 6, **dadurch gekennzeichnet, dass** die metallischen Umfangsbereiche eine Dicke besitzen, die im Wesentlichen gleich oder größer als 30 Mikrometer (30 µm) ist.

9. Elektronische Karte nach Anspruch 7, **dadurch gekennzeichnet, dass** die Öffnungen des Klebstofffilms einen Durchmesser besitzen, der größer als jener der mehreren Öffnungen des isolierenden Trägers ist.

10. Elektronische Karte nach Anspruch 7 oder 9, **dadurch gekennzeichnet, dass** sich das Lötmittel in jeder Öffnung der Öffnungen des Klebstofffilms befindet.

## Claims

1. Electronic card (82; 84; 98, 98A; 110; 120; 144, 148) comprising:
- an external connector (78; 78A; 90; 104; 114; 116; 136, 140) which comprises an insulating substrate (6), defining an outer surface (31) and an inner surface (33) which are opposite one another, and a plurality of outer metal contact pads (4) which are arranged on said outer surface of said insulating substrate;
- a card body (12; 66) which has a recess (14) in which said external connector is arranged;
- an electronic unit and/or an antenna incorporated in said card body and electrically connected to a plurality of inner metal contact pads (20) which are arranged in the card body, beneath the external connector, or on a surface of said recess and which are aligned respectively on the plurality of outer metal contact pads in a direction that is perpendicular to said outer surface;
said plurality of outer metal contact pads being respectively electrically connected to the plurality of inner metal contact pads by a plurality of metal parts (18, 34, 80; 18, 62, 8, 80; 100, 100A, 100B, 100C, 100D) which are each formed at least in part by a brazing material (18; 62; 95; 132) and which pass through said insulating substrate through a plurality of respective openings (92) provided in said insulating substrate;
said electronic card being **characterised in that** said plurality of metal parts are each covered by the plurality of outer metal contact pads which close said plurality of openings in the insulating substrate on the side of its outer surface, the plurality of metal parts each forming junction bridges between the rear surfaces (5) of the plurality of outer metal contact pads and said plurality of inner metal contact pads, **in that** said openings in said insulating substrate have a diameter of greater than 0.2 mm (200 µm), and **in that** most of each of said openings having a relatively large diameter is filled with metal.

2. Electronic card according to claim 1, **characterised in that** said metal parts have, in said openings in said insulating substrate, a diameter that is large enough to channel, during the production of the electronic card, heat through said insulating substrate which is sufficient to melt said brazing material positioned at or below said inner surface of the insulating substrate and to thus weld said connector to the plurality of inner metal contact pads.

3. Electronic card according to either claim 1 or claim 2, **characterised in that** said plurality of openings (92) in said insulating substrate each have a diameter of greater than 0.5 mm (500 µm).

4. Electronic card according to any of the preceding claims, **characterised in that** said plurality of openings (92) are substantially completely filled with metal, at least most of which is formed by a brazing material.

5. Electronic card according to claim 4, **characterised in that** said plurality of openings in the insulating substrate (6) have their side wall covered by a metal layer (106, 106A) which forms an adhesion interface for said brazing material positioned in said openings.

6. Electronic card according to any of the preceding claims, **characterised in that** peripheral metal pads (107), which each surround the openings of said plurality of openings in the insulating substrate, are arranged on said inner surface of said insulating substrate.

7. Electronic card according to any of the preceding claims, **characterised in that** an adhesive film (36), which has openings that are each aligned with said openings of said plurality of openings in the insulating substrate, is arranged between said inner surface of said insulating substrate and a surface of said recess positioned so as to face said inner surface.

8. Electronic card according to claim 6, **characterised in that** said peripheral metal pads have a thickness that is substantially equal to or greater than 30 micrometres (30 µm).

9. Electronic card according to claim 7, **characterised in that** the openings in the adhesive film have a greater diameter than that of said plurality of openings in the insulating substrate.

10. Electronic card according to either claim 7 or claim 9, **characterised in that** the brazing material is positioned in each opening of said openings in said adhesive film.
